# EUROPÄISCHE PATENTANMELDUNG

(11) **EP 3 179 633 A1**
(43) Veröffentlichungstag der Anmeldung: **14.06.2017**
(21) Anmeldenummer: 16002570.6
(22) Anmeldetag: 02.12.2016
(51) Int. Cl.: H03K 17/96

(54) **BERÜHRUNGS- UND/ODER ANNÄHERUNGSEMPFINDLICHER TASTSCHALTER**

(30) Priorität: 09.12.2015 DE 102015015927
(71) Anmelder: Diehl AKO Stiftung & Co. KG, 88239 Wangen (DE)
(72) Erfinder: Nowak, Michal, PL - 55-093 Kielczów (PL); Meller, Pawel, PL - 51-354 Wroclaw (PL); Dulski, Bartosz, PL - 55-080 Mokronos Górny (PL)
(74) Vertreter: Diehl Patentabteilung

(57) **Zusammenfassung**

Ein kapazitiver berührungs- und/oder annäherungsempfindlicher Tastschalter (10) weist eine Abdeckplatte (12), die auf einer einem Benutzer zugewandten Vorder-seite (121) ein Bedienungsfeld (14) definiert und zumindest im Bereich des Bedienungsfeldes (14) elektrisch isolierend und wenigstens teilweise lichtdurchlässig ausgebildet ist, und eine Trägerplatte (18), die auf einer dem Benutzer abgewandten Seite der Abdeckplatte (12) mit einem Abstand zu dieser angeordnet ist und eine elektrische Kontaktfläche (20) aufweist, auf. Ein Kopplungselement (22), das zwischen der Abdeckplatte (12) und der Trägerplatte (18) dem Bedienungsfeld (14) korrespondierend angeordnet ist und mit der elektrischen Kontaktfläche (20) der Trägerplatte (18) elektrisch leitend in Kontakt steht, weist einen elektrisch leitfähigen, lichtundurchlässigen Hohlkörper (221) auf, wobei der Hohlkörper (221) mit der elektrischen Kontaktfläche (20) der Trägerplatte (18) elektrisch leitend in Kontakt steht und einen Hohlraum (222) aufweist, der sich in einer Richtung zwischen der Trägerplatte (18) und der Abdeckplatte (12) erstreckt. Außerdem ist eine Lichtquelle (24) so auf der Trägerplatte (18) montiert, dass ein von ihr emittiertes Licht in Richtung zur Abdeckplatte (12) in den Hohlraum (222) des Hohlkörpers (221) des Kopplungs-elements (22) einkoppelt.

## Beschreibung

Die vorliegende Erfindung betrifft einen berührungs- und/oder annäherungsempfindlichen Tastschalter, insbesondere einen kapazitiven berührungs- und/ oder annäherungsempfindlichen Tastschalter.

In vielen elektronischen Geräten, insbesondere auch in Haushaltsgeräten wie Kochfeldern, Herden, Mikrowellenöfen, Spülmaschinen, Waschmaschinen, Wäschetrocknern, Kühlschränken und dergleichen, werden häufig berührungs- und/oder annäherungsempfindliche Tastschalter eingesetzt, die durch ein einfaches Berühren oder Annähern eines Bedienungsfeldes durch einen Benutzer bzw. einen Finger eines Benutzers zum Beispiel einen bestimmten Schaltvorgang auslösen oder eine Geräteeinstellung ändern können.

Um den Bedienungskomfort für den Benutzer zu verbessern, kann es vorteilhaft sein, das Bedienungsfeld des Tastschalters optisch zu kennzeichnen. Es sind im Stand der Technik verschiedene Lösungen bekannt, bei denen eine Lichtquelle (z.B. Leuchtdiode) auf der Trägerplatte hinter der Abdeckplatte angeordnet ist, mit welcher das Bedienungsfeld hinterleuchtet werden kann. In diesem Zusammenhang schlägt zum Beispiel die DE 10 2007 050 654 A1 vor, als kapazitives Sensorelement eine Druckfeder aus einem elektrisch leitenden Material zu verwenden und in den zentralen Durchgang der Druckfeder einen elektrisch isolierenden Lichtleiter hinein ragen zu lassen, durch den das von einer Lichtquelle auf der Trägerplatte emittierte Licht zum Bedienungsfeld der Abdeckplatte geleitet werden kann. Die DE 10 2009 005 008 A1 offenbart eine Variante dieser Konstruktion, bei der das Lichtleitelement einen ersten Abschnitt neben der Druckfeder und einen zweiten Abschnitt zwischen der Druckfeder und der Abdeckplatte aufweist.

Ferner offenbart die DE 10 2010 006 777 A1 einen berührungs- und/oder annäherungsempfindlichen Tastschalter, bei dem die Funktionalitäten des kapazitiven Sensorelements und des Lichtleitelements in einem speziellen Kopplungselement kombiniert sind. Hierzu weist das Kopplungselement einen lichtdurchlässigen und zugleich elektrisch leitfähigen Kunststoffkörper auf, der zwischen der Trägerplatte und der Abdeckplatte korrespondierend zum Bedienungsfeld angeordnet ist.

Der Erfindung liegt die Aufgabe zugrunde, einen verbesserten berührungs- und/oder annäherungsempfindlichen Tastschalter zu schaffen, der eine hohe Zuverlässigkeit aufweist und einen hohen Bedienungskomfort bietet.

Diese Aufgabe wird gelöst durch einen berührungs- und/oder annäherungsempfindlichen Tastschalter mit den Merkmalen des Anspruchs 1. Besonders bevorzugte Ausgestaltungen und Weiterbildungen der Erfindung sind Gegenstand der abhängigen Ansprüche.

Der berührungs- und/oder annäherungsempfindlicher Tastschalter der Erfindung weist eine Abdeckplatte, die auf einer einem Benutzer zugewandten Vorderseite ein Bedienungsfeld definiert und zumindest im Bereich dieses Bedienungsfeldes elektrisch isolierend und wenigstens teilweise lichtdurchlässig ausgebildet ist; eine Trägerplatte, die auf einer dem Benutzer abgewandten Seite der Abdeckplatte mit einem Abstand zu dieser angeordnet ist und eine elektrische Kontaktfläche aufweist; ein Kopplungselement, das zwischen der Abdeckplatte und der Trägerplatte dem Bedienungsfeld korrespondierend angeordnet ist und mit der elektrischen Kontaktfläche der Trägerplatte elektrisch leitend in Kontakt steht; und eine Lichtquelle, die auf der Trägerplatte montiert ist, auf. Das Kopplungselement des erfindungsgemäßen Tastschalters weist einen elektrisch leitfähigen, lichtundurchlässigen Hohlkörper auf, der mit der elektrischen Kontaktfläche der Trägerplatte elektrisch leitend in Kontakt steht und einen Hohlraum aufweist, der sich in einer Richtung zwischen der Trägerplatte und der Abdeckplatte erstreckt. Ferner ist die Lichtquelle so auf der Trägerplatte montiert, dass ein von ihr emittiertes Licht in Richtung zur Abdeckplatte in den Hohlraum des Hohlkörpers des Kopplungselements einkoppelt.

Der berührungs- und/oder annäherungsempfindliche Tastschalter gemäß der Erfindung weist ein spezielles Kopplungselement auf, das im Wesentlichen aus einem elektrisch leitfähigen, lichtundurchlässigen Hohlkörper besteht. Dieses Kopplungselement kombiniert so einerseits mittels der Wandung des Hohlkörpers die Funktionalität eines mit der elektrischen Kontaktfläche der Trägerplatte verbundenen Sensorelements und andererseits mittels des Hohlraums des Hohlkörpers die Funktionalität eines Lichtleitelements zur Hinterleuchtung des Bedienungsfeldes der Abdeckplatte. Der Hohlraum ist optisch transparent ausgestaltet. Bevorzugt befindet sich im Hohlraum Luft, alternativ ist der Hohlraum ganz oder teilweise mit einem organischen oder einem anorganischen Werkstoff gefüllt.

Im Gegensatz zum Beispiel zu dem aus der DE 10 2010 006 777 A1 bekannten Kopplungselement aus einem elektrisch leitfähigen und zugleich lichtdurchlässigen Kunststoffkörper können mit dem Kopplungselement des erfindungsgemäßen Tastschalters beide Funktionalitäten optimiert werden, da einerseits der Hohlkörper selbst eine gute elektrische Leitfähigkeit aufweisen kann und andererseits sein Hohlraum einen hohen Transmissionsgrad für das von der Lichtquelle emittierte Licht aufweist. Im Ergebnis können die Effizienz und Zuverlässigkeit des Tastschalters beim Erkennen einer Berührung oder Annäherung des Bedienungsfeldes durch einen Benutzer und der Bedienungskomfort für den Benutzer durch eine effizientere Hinterleuchtung verbessert werden.

Bei dem berührungs- und/oder annäherungsempfindlichen Tastschalter der Erfindung handelt es sich vorzugsweise um einen kapazitiven Tastschalter. D.h. das Kopplungselement bildet ein kapazitives Sensorelement, indem die der Abdeckplatte zugewandte Stirnseite des Hohlkörpers des Kopplungselements eine elektrisch leitende Kopplungsfläche bereitstellt, die mit einem Benutzer über die als Dielektrikum wirkende Abdeckplatte eine Kapazität bilden kann, deren Wert bzw. Wertänderung von einer mit dem Tastschalter verbundenen Auswerteelektronik erkannt werden kann.

Die Abdeckplatte soll "im Bereich des Bedienungsfeldes elektrisch isolierend und wenigstens teilweise lichtdurchlässig" ausgebildet sein. Dies bedeutet in Zusammenhang mit der vorliegenden Erfindung, dass die Abdeckplatte zumindest im Bereich des Bedienungsfeldes elektrisch isolierend ausgebildet ist, sodass sie in diesem Bereich als ein Dielektrikum für das kapazitive Sensorelement dienen kann. Andere Bereiche der Abdeckplatte können wahlweise elektrisch isolierend oder auch elektrisch leitfähig ausgebildet sein. Die Abdeckplatte ist vorzugsweise aus Kunststoff, Glas, Glaskeramik oder dergleichen gebildet. Außerdem muss das Bedienungsfeld nicht vollständig lichtdurchlässig ausgestaltet sein. Durch das Vorsehen lichtdurchlässiger und lichtundurchlässiger Abschnitte können zum Beispiel Symbole oder dergleichen dargestellt werden, die mittels der Lichtquelle hinterleuchtet werden können. Wahlweise kann so auch eine Kontur des Bedienungsfeldes alternativ oder zusätzlich zu einem Symbol oder dergleichen hinterleuchtet werden.

Die Begriffe "lichtdurchlässig" und "lichtundurchlässig" beziehen sich in Zusammenhang mit der vorliegenden Erfindung jeweils auf die von der Lichtquelle emittierte Strahlung. Dabei emittiert die Lichtquelle bevorzugt Licht im sichtbaren Wellenlängenbereich (etwa 380 - 780 nm). Lichtdurchlässigkeit soll dabei - bezogen auf die jeweilige Wellenlänge - einen Transmissionsgrad von vorzugsweise wenigstens etwa 50%, bevorzugt wenigstens etwa 75% bedeuten. Lichtundurchlässigkeit soll dabei - bezogen auf die jeweilige Wellenlänge - einen Transmissionsgrad von vorzugsweise höchstens etwa 20%, bevorzugt höchstens etwa 10% bedeuten.

Im Rahmen der vorliegenden Erfindung kann die "Trägerplatte" zum Beispiel eine Leiterplatte oder eine einfache Kunststoffplatte sein. Die Trägerplatte kann außerdem als stabiler Plattenkörper ausgebildet sein oder nur Folienstärke besitzen. Die Trägerplatte kann im Wesentlichen parallel zur Abdeckplatte ausgerichtet sein oder in einem Winkel von bis zu 90° zu dieser stehen. Auf der Trägerplatte ist im Allgemeinen auch die Auswerteelektronik zum Verarbeiten und Auswerten der von der Sensorschaltung erzeugten Ausgangssignale, um ein Betätigen des Schalters durch ein Berühren/Annähern bzw. Nicht-Berühren/Annähern festzustellen, vorgesehen. Von dieser Auswerteelektronik zu unterscheiden ist die Steuerung z. B. des Haushaltsgerätes, mit welcher die Auswerteelektronik verbunden ist und welche wahlweise ebenfalls auf der Trägerplatte oder an einer anderen Stelle im Haushaltsgerät angeordnet sein kann. In einigen Anwendungen kann die Auswerteelektronik auch in diese Steuerung integriert sein.

Das Kopplungselement ist "dem Bedienungsfeld korrespondierend" angeordnet. Im Rahmen dieser Erfindung soll dies bedeuten, dass die Dimensionierung, die Form und/oder die Platzierung des Kopplungselements bzw. dessen Hohlkörpers hinter der Abdeckplatte die Dimensionierung, die Form bzw. die Position des Bedienungsfeldes auf der Abdeckplatte bestimmen. Das Bedienungsfeld kann für den Benutzer auf der Abdeckplatte zusätzlich optisch und/oder haptisch gekennzeichnet sein, um die Bedienung durch den Benutzer zu vereinfachen.

Gemäß der Erfindung weist das Kopplungselement einen Hohlkörper mit einem Hohlraum auf. Vorzugsweise ist der Hohlkörper zylindrisch oder rohrförmig ausgestaltet, wobei die Querschnittsform des Hohlkörpers grundsätzlich beliebig sein kann, bevorzugt aber im Wesentlichen kreisförmig oder quadratisch ist. Der Hohlraum des Hohlkörpers hat vorzugsweise im Wesentlichen die gleiche Querschnittsform wie der Hohlkörper. Der Hohlraum des Hohlkörpers ist vorzugsweise leer, sodass ein hoher Transmissionsgrad für das von der Lichtquelle emittierte Licht gewährleistet werden kann. Der Begriff "lichtundurchlässig" bezieht sich in diesem Zusammenhang nur auf die Wandung des Hohlkörpers, während der Hohlraum des Hohlkörpers selbstverständlich lichtdurchlässig ist, sodass das Kopplungselement bzw. der Hohlkörper in seiner Längsrichtung lichtdurchlässig ist und in Radialrichtung quer zur Längsrichtung lichtundurchlässig ist.

Die Lichtquelle ist so auf der Trägerplatte montiert, dass ein von ihr emittiertes Licht in Richtung zur Abdeckplatte in den Hohlraum des Hohlkörpers dieses Kopplungselements einkoppelt. D.h. die Lichtquelle ist bevorzugt innerhalb des Hohlraums des Hohlkörpers auf der Trägerplatte montiert, sodass die Lichtquelle das Licht direkt in den Hohlraum in Richtung zur Abdeckplatte hin aussendet. Die Lichtquelle emittiert vorzugsweise Licht im sichtbaren Wellenlängenbereich (etwa 380 - 780 nm). Die Wellenlänge des von der Lichtquelle emittierten Lichts kann in einer Ausgestaltung der Erfindung auch veränderbar sein, sodass das Bedienungsfeld zum Beispiel je nach Betriebszustand des Tastschalters oder des Geräts mit verschiedenen Farben hinterleuchtet werden kann. Bei der Lichtquelle handelt es sich vorzugsweise um oder mehrere Leuchtdioden. Die Lichtquelle ist bevorzugt auf der dem Kopplungselement zugewandten Seite der Trägerplatte montiert, kann aber alternativ auch auf der anderen Seite montiert sein, wenn die Trägerplatte eine entsprechende Durchbrechung für das Licht aufweist.

In einer bevorzugten Ausgestaltung der Erfindung kann das Kopplungselement auf einer der Abdeckplatte zugewandten Seite des Hohlkörpers eine zumindest teilweise lichtdurchlässige und zumindest teilweise elektrisch leitfähige Sensorplatte aufweisen, die elektrisch leitend mit dem Hohlkörper in Kontakt steht und den Hohlraum des Hohlkörpers auf der der Abdeckplatte zugewandten Seite des Kopplungselements zumindest teilweise verschließt. Mit Hilfe dieser Sensorplatte kann die elektrisch leitfähige Sensorfläche des Kopplungselements - ausgehend von allein der durch die Wandung des Hohlkörpers gebildeten Stirnfläche - vergrößert werden. Im Ergebnis können die Zuverlässigkeit und die Effizienz des Tastschalters beim Erkennen einer Betätigung des Tastschalters durch einen Benutzer weiter erhöht werden.

Bei dieser Ausgestaltung ist die Sensorplatte vorzugsweise mit einer (zweiten) Kopplungsfläche des Hohlkörpers auf der der Abdeckplatte zugewandten Seite des Kopplungselements elektrisch leitend verbunden. Die Verbindung ist bevorzugt durch Verlöten oder ein Verkleben mit einem elektrisch leitfähigen Klebemittel ausgeführt.

Bei dieser Ausgestaltung weist die Sensorplatte vorzugsweise zudem eine Maske mit lichtdurchlässigen Bereichen und lichtundurchlässigen Bereichen auf. Mittels einer solchen Maske kann zum Beispiel ein Symbol oder dergleichen in die Hinterleuchtung des Bedienungsfeldes integriert werden, um dieses für den Benutzer besser zu kennzeichnen.

Die Sensorplatte des Kopplungselements ist bevorzugt aus einem lichtdurchlässigen Kunststoffmaterial gefertigt, das mittels geeigneter Maßnahmen (z.B. Integration elektrisch leitfähiger Partikel, elektrisch leitfähige Beschichtung, Überzug mit einem elektrisch leitfähigen Netz, etc.) elektrisch leitfähig gemacht ist. Die Sensorplatte weist vorzugsweise Folienstärke (z.B. etwa 50 µm bis etwa 1 mm) auf, kann aber auch eine Plattenstärke von wenigen mm besitzen.

Die Sensorplatte steht mit der Rückseite der Abdeckplatte vorzugsweise in engem Kontakt. Dabei ist die Sensorplatte vorzugsweise lösbar gegen die Abdeckplatte gedrückt, kann aber auch fest mit dieser verbunden sein. Alternativ ist die Sensorplatte fest mit der beabstandeten Abdeckplatte verbunden.

In einer weiteren bevorzugten Ausgestaltung der Erfindung kann der Hohlkörper des Kopplungselements in einer Verbindungsrichtung zwischen der Trägerplatte und der Abdeckplatte zumindest teilweise elastisch ausgestaltet sein. Durch diese Elastizität des Hohlkörpers können bei der Montage des Tastschalters vorzugsweise Fertigungs- und Montagetoleranzen ausgeglichen werden und kann ein enger Kontakt zwischen dem Kopplungselement und der Abdeckplatte gewährleistet werden. Falls das Kopplungselement nicht fest mit der Trägerplatte verbunden ist, kann so auch eine sichere elektrisch leitende Verbindung zwischen dem Kopplungselement und der elektrischen Kontaktfläche der Trägerplatte gewährleistet werden.

Die Elastizität des Hohlkörpers des Kopplungselements kann bevorzugt durch die Verwendung eines elastischen Materials oder eine strukturelle Modifikation des Hohlkörpers erzielt werden. So kann zum Beispiel der gesamte Hohlkörper aus einem elastischen Material (z.B. Kunststoff, Elastomer, Schaum, etc.) gefertigt sein. Alternativ kann der Hohlkörper nur abschnittweise aus einem elastischen Material gefertigt oder elastisch ausgestaltet (z.B. Materialschwächung, Balgstruktur, etc.) sein.

In einer weiteren bevorzugten Ausgestaltung der Erfindung kann eine Innenwand des Hohlkörpers des Kopplungselements zumindest teilweise lichtreflektierend ausgestaltet sein. Durch die lichtreflektierende Ausgestaltung der Hohlkörper-Innenwand kann der Transmissionsgrad des von der Lichtquelle emittierten Lichts durch den Hohlraum erhöht werden. Der Reflexionsgrad der Innenwand beträgt - bezogen auf die jeweilige Wellenlänge - bevorzugt wenigstens etwa 50%, bevorzugter wenigstens etwa 70% oder wenigstens etwa 80%. Die Reflexionseigenschaft der Innenwand kann vorzugsweise durch eine entsprechende Oberflächenbehandlung oder Beschichtung der Innenwand und/oder eine entsprechende Materialauswahl für den Hohlkörper erzielt werden.

Der oben beschriebene berührungs- und/oder annäherungsempfindliche Tastschalter gemäß der Erfindung ist in vorteilhafter Weise in elektronischen Geräten, insbesondere Haushaltsgeräten, insbesondere in deren Bedienblenden einsetzbar.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnung besser verständlich. Darin zeigen, größtenteils schematisch:
- Fig. 1: eine Schnittansicht eines Tastschalters gemäß einem Ausführungsbeispiel der vorliegenden Erfindung; und
- Fig. 2: eine perspektivische Schnittansicht des Tastschalters von Fig. 1.

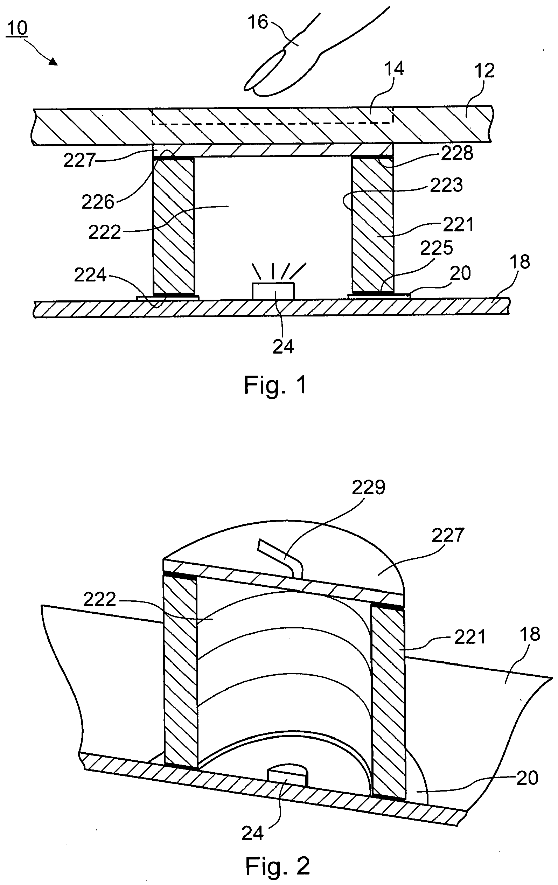

Bezug nehmend auf Fig. 1 und 2 wird nun ein kapazitiver berührungs- und/oder annäherungsempfindlicher Tastschalter gemäß einem bevorzugten Ausführungsbeispiel näher erläutert, der beispielsweise in einer Bedienblende eines elektronischen Haushaltsgeräts (z.B. Kochfeld, Herd, Spülmaschine, Wäschebehandlungsgerät, Kühl- und/oder Gefriergerät, etc.) eingesetzt werden kann.

Der kapazitive Tastschalter 10 weist eine lichtdurchlässige und elektrisch nicht leitfähige Abdeckplatte 12 aus zum Beispiel Glaskeramik oder Kunststoff auf, auf deren einem Benutzer zugewandter Vorderseite 121 (oben in Fig. 1, Außenseite des Geräts) ein Bedienungsfeld 14 definiert ist. Der Benutzer kann den Tastschalter 10 durch eine Berührung oder Annäherung des Bedienungsfeldes 14 mit zum Beispiel einem Finger 16 betätigen, um zum Beispiel einen Schaltvorgang auszulösen oder eine Geräteeinstellung zu verändern.

Auf der dem Benutzer abgewandten Rückseite 122 der Abdeckplatte 12 ist mit Abstand zu dieser eine Trägerplatte 18 angeordnet. Bei der Trägerplatte 18 handelt es sich beispielsweise um eine Leiterplatte, die im Wesentlichen parallel zur Abdeckplatte 14 angeordnet ist. Auf der Trägerplatte 18 ist auf der der Abdeckplatte 12 zugewandten Seite eine elektrische Kontaktfläche 20 vorgesehen. Diese Kontaktfläche 20 ist in diesem Ausführungsbeispiel kreisringförmig ausgestaltet. Die Kontaktfläche 20 ist mit einer Auswerteelektronik (nicht dargestellt) verbunden, die vorzugsweise ebenfalls auf der Trägerplatte 18 montiert ist.

Der erfindungsgemäße Tastschalter 10 weist ferner ein Kopplungselement 22 auf, das zwischen der Abdeckplatte 12 und der Trägerplatte 18 angeordnet ist. Dieses Kopplungselement 22 weist insbesondere einen zylindrischen bzw. rohrförmigen Hohlkörper 221 mit einer kreisförmigen Querschnittsform auf. Der Hohlkörper 221 weist einen Hohlraum 222 auf, der sich in der Längsrichtung des Hohlkörpers 221 (Oben/Unten-Richtung in Fig. 1) durch diesen hindurch erstreckt. Dabei hat der Hohlraum 222 eine im Wesentlichen kreisförmige Querschnittsform und ist im Wesentlichen zentral im Hohlkörper 221 angeordnet.

Der Hohlkörper 221 ist elektrisch leitfähig ausgestaltet, um ein kapazitives Sensorelement des Tastschalters 10 zu bilden. Zum Beispiel ist der Hohlkörper 221 aus Metall oder einem elektrisch leitfähigen Kunststoffmaterial oder Silikon gefertigt. An der der Trägerplatte 18 zugewandten Stirnseite des Hohlkörpers 221 ist eine erste elektrisch leitfähige Kopplungsfläche 224 vorgesehen. Diese erste Kopplungsfläche 224 steht bevorzugt über eine elektrisch leitfähige Verbindung 225 (z.B. Lötverbindung oder Klebeverbindung) mit der Kontaktfläche 20 der Trägerplatte 18 elektrisch leitend in Kontakt. Die der Abdeckplatte 12 zugewandte Stirnseite des Hohlkörpers 221 (oben in Fig. 1) definiert Position, Form und Größe des Bedienungsfeldes 14 der Abdeckplatte 12.

Der Hohlkörper 221 bzw. seine Wandung ist zudem im Wesentlichen lichtundurchlässig ausgestaltet, sodass sein Hohlraum 222 als "Lichtleitelement" funktionieren kann. Die Lichtundurchlässigkeit kann beispielsweise durch die Materialauswahl des Hohlkörpers 221 und/oder eine Beschichtung der Innenwand 223 erzielt werden.

Diesbezüglich ist ferner auf der Trägerplatte 18 eine Lichtquelle 24 in Form einer oder mehrerer Leuchtdioden montiert. In dem gezeigten Ausführungsbeispiel ist die Lichtquelle 24 beispielhaft auf der der Abdeckplatte 12 zugewandten Seite der Trägerplatte 18 und im Wesentlichen mittig innerhalb des Hohlkörpers 221 bzw. seines Hohlraums 222 angeordnet. Auf diese Weise koppelt die Lichtquelle 24 das von ihr emittierte sichtbare Licht in Richtung zur Abdeckplatte 12 in den Hohlraum 222 ein. Das Licht wird dann durch den leeren Hohlraum 222 zur Abdeckplatte 12 und durch diese hindurch geleitet, sodass das Bedienungsfeld 14 der Abdeckplatte 12 hinterleuchtet werden kann.

Zur Verbesserung der Lichtleitereigenschaften des Kopplungselements 22 kann die Innenwand 223 des Hohlkörpers 221 zudem reflektierend ausgestaltet sein. Dies geschieht zum Beispiel durch eine Beschichtung oder Oberflächenbehandlung der Innenwand 223 und/oder eine geeignete Materialauswahl für den Hohlkörper 221 des Kopplungselements 22.

Um die Sensorfläche des kapazitiven Tastschalters 10 zu vergrößern, weist das Kopplungselement 22 vorzugsweise eine Sensorplatte 227 auf. Diese Sensorplatte 227 ist elektrisch leitfähig und zumindest teilweise lichtdurchlässig ausgestaltet. Die Sensorplatte 227 steht über eine elektrisch leitfähige Verbindung 228 (z.B. Löt- oder Klebeverbindung) mit einer zweiten elektrisch leitfähigen Kopplungsfläche 226 an der der Abdeckplatte 12 zugewandten Stirnseite des Hohlkörpers 221 elektrisch leitend in Kontakt.

Die Sensorplatte 227 ist beispielsweise in Folienstärke ausgebildet. Auf diese Weise bleibt ein ausreichend hoher Transmissionsgrad des Kopplungselements 22 für das von der Lichtquelle 24 emittierte Licht zur Abdeckplatte 12 möglich. Die Sensorplatte 227 ist optional zudem mit einer Maske 229 versehen, um zum Beispiel ein oder mehrere Symbole oder dergleichen darzustellen und so zum Beispiel die Funktionalität des Bedienungsfeldes 14 für den Benutzer zu kennzeichnen. Die Maske 229 ist beispielsweise in die Sensorplatte 227 integriert oder auf diese aufgedruckt.

Durch die kombinierte Funktionalität des Kopplungselements 22 als kapazitives Sensorelement und als Lichtleitelement in nur einem Bauelement sind Aufbau und Montage des Tastschalters 10 relativ einfach. Dabei kann zum Beispiel der Hohlkörper 221 des Kopplungselements 22 als Standardkomponente vorgehalten werden, die für unterschiedliche Tastschalter 10 eingesetzt werden kann, während nur die Sensorplatte 227, die im Allgemeinen kostenaufwändiger ist, anwendungsspezifisch angepasst werden muss. Beispielsweise kann der Hohlkörper 221 des Kopplungselements 22 aus einem extrudierten Schlauchmaterial auf die gewünschten Längen geschnitten werden.

In einer Modifikation dieses Ausführungsbeispiels ist der Hohlkörper 221 in seiner Längsrichtung (d.h. Verbindungsrichtung zwischen Abdeckplatte 12 und Trägerplatte 18) zumindest teilweise elastisch ausgestaltet. Auf diese Weise kann das Kopplungselement 22 zwischen die Abdeckplatte 12 und die Trägerplatte 18 geklemmt werden und durch seine Elastizität Fertigungs- und Montagetoleranzen ausgleichen, um ein möglichst enges Anliegen der Sensorplatte 227 an der Rückseite 122 der Abdeckplatte 12 und ggf. - im Fall nur loser Verbindungen - auch möglichst gute elektrisch leitende Kontakte der ersten und zweiten Kopplungsfläche 224, 226 des Kopplungselements 22 mit der Sensorplatte 227 bzw. der elektrischen Kontaktfläche 20 der Trägerplatte 18 zu gewährleisten.

Die Elastizität des Hohlkörpers 221 des Kopplungselements 22 kann zum Beispiel durch eine entsprechende Materialwahl für den Hohlkörper erzielt werden. So kann der Hohlkörper 22 zum Beispiel aus einem elastischen Kunststoff, einem Elastomer, einem Schaumwerkstoff, einem Silikon oder dergleichen gefertigt sein, der beispielsweise mittels Zusatzstoffen, Beschichtungen, Netzen, etc. elektrisch leitfähig gemacht ist. Alternativ ist der Hohlkörper 22 nur abschnittweise aus einem solchen elastischen Material gemacht, im Übrigen aus einem im Wesentlichen unelastischen Material (z.B. Metall) gemacht. Alternativ oder zusätzlich kann die Elastizität auch durch strukturelle Maßnahmen wie zum Beispiel Materialschwächungen, Balgkonstruktionen oder dergleichen erreicht werden.

In einer weiteren Modifikation des Ausführungsbeispiels kann alternativ oder zusätzlich auch die Sensorplatte 227 des Kopplungselements 22 elastisch ausgestaltet sein, um die gleichen Vorteile zu erzielen.

### BEZUGSZIFFERNLISTE

- 10: Tastschalter
- 12: Abdeckplatte
- 121: Vorderseite
- 122: Rückseite
- 14: Bedienungsfeld
- 16: Finger
- 18: Trägerplatte
- 20: Kontaktfläche
- 22: Kopplungselement
- 221: Hohlkörper
- 222: Hohlraum
- 223: Innenwand
- 224: erste Kopplungsfläche
- 225: Verbindung
- 226: zweite Kopplungsfläche
- 227: Sensorplatte
- 228: Verbindung
- 229: Maske
- 24: Lichtquelle

## Patentansprüche

1. Berührungs- und/oder annäherungsempfindlicher Tastschalter (10), aufweisend:
eine Abdeckplatte (12), die auf einer einem Benutzer zugewandten Vorderseite (121) ein Bedienungsfeld (14) definiert und zumindest im Bereich des Bedienungsfeldes (14) elektrisch isolierend und wenigstens teilweise lichtdurchlässig ausgebildet ist;
eine Trägerplatte (18), die auf einer dem Benutzer abgewandten Seite der Abdeckplatte (12) mit einem Abstand zu dieser angeordnet ist und eine elektrische Kontaktfläche (20) aufweist;
ein Kopplungselement (22), das zwischen der Abdeckplatte (12) und der Trägerplatte (18) dem Bedienungsfeld (14) korrespondierend angeordnet ist und mit der elektrischen Kontaktfläche (20) der Trägerplatte (18) elektrisch leitend in Kontakt steht; und
eine Lichtquelle (24), die auf der Trägerplatte (18) montiert ist,
**dadurch gekennzeichnet, dass**
das Kopplungselement (22) einen elektrisch leitfähigen, lichtundurchlässigen Hohlkörper (221) aufweist,
wobei der Hohlkörper (221) mit der elektrischen Kontaktfläche (20) der Trägerplatte (18) elektrisch leitend in Kontakt steht und einen Hohlraum (222) aufweist, der sich in einer Richtung zwischen der Trägerplatte (18) und der Abdeckplatte (12) erstreckt; und
die Lichtquelle (24) so auf der Trägerplatte (18) montiert ist, dass ein von ihr emittiertes Licht in Richtung zur Abdeckplatte (12) in den Hohlraum (222) des Hohlkörpers (221) des Kopplungselements (22) einkoppelt.

2. Berührungs- und/oder annäherungsempfindlicher Tastschalter nach Anspruch 1, bei welchem
das Kopplungselement (22) auf einer der Abdeckplatte (12) zugewandten Seite des Hohlkörpers (221) eine zumindest teilweise lichtdurchlässige und zumindest teilweise elektrisch leitfähige Sensorplatte (227) aufweist, die elektrisch leitend mit dem Hohlkörper (221) in Kontakt steht und den Hohlraum (222) des Hohlkörpers (221) auf der der Abdeckplatte zugewandten Seite des Kopplungselements zumindest teilweise verschließt.

3. Berührungs- und/oder annäherungsempfindlicher Tastschalter nach Anspruch 2, bei welchem
die Sensorplatte (227) mit einer zweiten Kopplungsfläche (226) des Hohlkörpers (221) auf der der Abdeckplatte zugewandten Seite des Kopplungselements elektrisch leitend verbunden ist.

4. Berührungs- und/oder annäherungsempfindlicher Tastschalter nach Anspruch 2 oder 3, bei welchem
die Sensorplatte (227) eine Maske (229) mit lichtdurchlässigen Bereichen und lichtundurchlässigen Bereichen aufweist.

5. Berührungs- und/oder annäherungsempfindlicher Tastschalter nach einem der vorhergehenden Ansprüche, bei welchem
der Hohlkörper (221) des Kopplungselements (22) in einer Verbindungsrichtung zwischen der Trägerplatte (18) und der Abdeckplatte (12) zumindest teilweise elastisch ausgestaltet ist.

6. Berührungs- und/oder annäherungsempfindlicher Tastschalter nach einem der vorhergehenden Ansprüche, bei welchem
eine Innenwand (223) des Hohlkörpers (221) des Kopplungselements (22) zumindest teilweise lichtreflektierend ausgestaltet ist.

7. Elektronisches Gerät, insbesondere Haushaltsgerät, aufweisend eine Bedienvorrichtung, welche wenigstens einen berührungs- und/oder annäherungsempfindlicher Tastschalter (10) nach einem der vorhergehenden Ansprüche aufweist.
